# EUROPEAN PATENT APPLICATION

(11) **EP 1 435 657 A1**
(43) Date of publication of application: **07.07.2004**
(21) Application number: 02425805.5
(22) Date of filing: 30.12.2002
(51) Int. Cl.: H01L 21/8247, H01L 27/115

(54) **Non-volatile memory cell and manufacturing process**

(71) Applicant: STMicroelectronics S.r.l., 20041 Agrate Brianza (Milano) (IT)
(72) Inventor: Pavan, Alessia, I-23807 Merate (Lecco) (IT); Clementi, Cesare, I-21052 Busto Arsizio (Varese) (IT); Baldi, Livio, I-20041 Agrate Brianza (Milano) (IT)
(74) Representative: Ferrari, Barbara

(57) **Abstract**

A non-volatile memory cell (1) is described, being integrated on a semiconductor substrate (2) and comprising:
- a floating gate transistor including a source region (S) and a drain region (G), a gate region projecting from the substrate (2) and comprised between the source and drain regions (S, D), the gate region having a predetermined length (L) and width (W) and comprising a first floating gate region (FG) and a control gate region (CG),
in which the floating gate region (FG) is insulated laterally, along the width (W) direction, by a dielectric layer (9) with low dielectric constant value (K).

A process for manufacturing non-volatile memory cells (1) on a semiconductor substrate (2) is also described, comprising the following steps:
- form active areas in the semiconductor substrate (2) bounded by an insulating layer (FOX),
- deposit a first conductor material layer (5) on active areas,
- define through a standard photolithographic technique a plurality of floating gate regions (FG),
- form a dielectric layer (9) with low dielectric constant value (K) on the floating gate regions (FG).

## Description

### Field of application

The present invention relates to a non-volatile memory cell comprising dielectric layers having low dielectric constant and corresponding process.

More specifically, the invention relates to a non-volatile memory cell integrated on a semiconductor substrate and comprising:
- a floating gate transistor including a source region and a drain region, a gate region projecting from the substrate and comprised between said source and drain regions, said gate region having a predetermined length and width and comprising a first floating gate region and a control gate region.

The invention relates also to a process for manufacturing non-volatile memory cells on a semiconductor substrate, comprising the following steps:
- form active areas in said semiconductor substrate bounded by an insulating layer,
- form on said active areas a first dielectric material layer,
- deposit a first conductor material layer on said first dielectric layer,
- define through a standard photolithographic technique a plurality of floating gate regions.

The invention relates particularly, but not exclusively, to a Flash non-volatile memory cell comprising dielectric layers with low dielectric constant and the following description is made with reference to this field of application for convenience of illustration only.

### Prior art

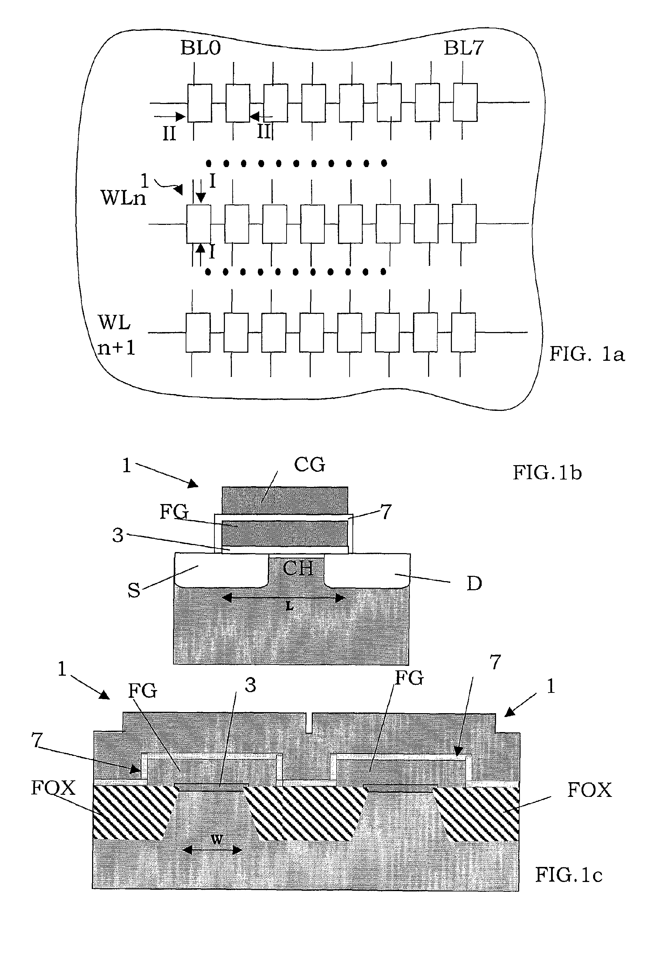

As it is well known, semiconductor-integrated Flash EPROM memory electronic devices comprise a plurality of matrix-organised non-volatile memory cells 1; i.e. that cells are organised according to rows, referred to as word lines WL, and columns, referred to as bit lines BL, as shown in figure 1a.

Each non-volatile cell 1 comprises a floating gate MOS transistor as shown in figure 1b. The floating gate region FG of the floating gate transistor is formed above the channel region CH formed in the semiconductor substrate 2 and separated from the latter through a thin oxide layer 3 (tunnel oxide) being about ∼10 nm thick. A control gate region CG is coupled in a capacitive way to the floating gate region FG through a single dielectric layer 7 or comprising several overlapped dielectric layers such as for example ONO (oxide/nitride/oxide).

The other transistor regions are the usual drain, source and body terminals. Metallic electrodes are provided to contact the drain and source terminals and the control gate region CG in order to allow predetermined voltage values to be applied to the memory cell 1.

The charge stored in the floating gate region FG determines the logic state of cell 1 by modifying the threshold voltage thereof: in fact a fundamental feature of the memory cell 1 is to have two states, the one with a low threshold voltage ("erased" cell) and the other with a high threshold voltage ("written" cell). The voltage is applied from the outside to the control gate region CG, but the electrode which effectively controls the channel state is the floating gate region FG.

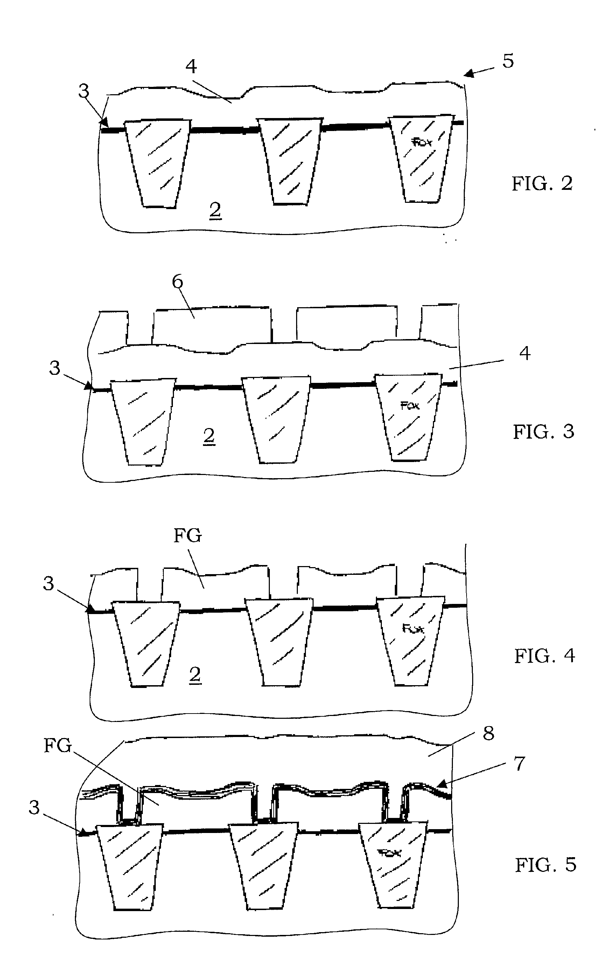

A known process flow to manufacture Flash memory cells 1 integrated on a semiconductor substrate 2 is shown in figures 2 to 5. These figures are vertical section views in a parallel direction to "Word Lines".

This known process provides that in the substrate a plurality of active areas, wherein memory cells will be formed, separated from each other by portions of a field oxide layer FOX, are formed. A first dielectric layer 3 referred to as "Tunnel Oxide" and a polycrystalline silicon layer 4 referred to as POLY1 are then formed on the substrate 2.

This polycrystalline silicon layer 4 which is about 50-200 nm thick is formed for example through LPCVD (Low Pressure Chemical Vapour Deposition). This polycrystalline silicon layer 4 is, in case, doped to reduce the resistivity thereof, for example through a phosphorus or arsenic implant or in situ by adding phosphin to the deposition environment.

The process continues with the definition of layer 4 to form a plurality of polycrystalline silicon strips 5 being parallel to each other. These strips 5 are separated and insulated from the substrate 2 by means of the oxide layer 3 as shown in figure 3.

Particularly, in this step, a photosensitive material layer 6 referred to as resist is deposited on the substrate 2 surface and it is exposed to a convenient radiation in predetermined areas which are not protected by a mask. The resist portions selectively exposed to the radiation have a higher removing speed than the non-exposed regions and they can thus be removed through a chemical solution referred to as developer. After the lithographic definition a dry etching of the polycrystalline silicon strips 5 is performed to define the floating gate regions FG.

After depositing an interpoly dielectric layer 7, the standard process flow continues with the "Word Line" definition by forming a polycrystalline silicon layer 8 (referred to as Poly2).

"Word Lines" are thus defined through a photolithographic process providing the use of a resist mask so that these word lines are located perpendicularly to the polysilicon strips 5.

Although advantageous under many aspects, this process flow has several drawbacks. In fact the area between two adjacent floating gates is completed with the deposition of the second polysilicon layer 8. Cell 1 is then filled up by dry etching.

Nevertheless, the decrease in size of the area between two adjacent floating gates (∼ 40-50 nm in the most advanced technologies) makes the filling with a material like polysilicon difficult.

It must be added that the interpoly dielectric layer 7 like ONO, being a high dielectric constant K material, increases the capacitive coupling between adjacent floating gate regions FG. This can cause undesired interactions between adjacent cells, especially if they are in different logic states.

The technical problem underlying the present invention is to provide a method for forming non-volatile memory cells, having such structural and functional characteristics as to allow the capacitive coupling between adjacent floating gate regions to be reduced, overcoming thus the limits that currently affect devices manufactured according to the prior art.

### Summary of the invention

The solutive idea underlying the present invention is to define a process sequence needed to obtain a memory device organised in rows and columns comprising non-volatile memory cells wherein the area between two adjacent floating gate regions belonging to the same row is filled up with low dielectric constant (low-k) material.

On the basis of this solutive idea the technical problem is solved by a memory cell as previously described and defined in the characterising part of claim 1.

The problem is solved also by a process as previously described and defined in the characterising part of claim 7.

The features and advantages of the device according to the invention will be apparent from the following description of an embodiment thereof given by way of non-limiting example with reference to the attached drawings.

### Brief description of the drawings

In the drawings:
- Figure 1a is a schematic view of a memory cell matrix portion in a semiconductor-integrated memory electronic device;
- Figure 1b is a sectional view along the line I-I of figure 1 of a standard memory cell;
- Figure 1c is a sectional view along the line II-II of figure 1 of a standard memory cell;
- Figures 2 to 5 show respective vertical sections in an enlarged scale of a semiconductor substrate portion during a process for manufacturing non-volatile memory cells according to the prior art;
- Figures 6 and 7 show respective vertical sections in an enlarged scale of a semiconductor substrate portion during a first embodiment of a process for manufacturing non-volatile memory cells according to the invention;
- Figures 8 and 9 show respective vertical sections in an enlarged scale of a semiconductor substrate portion during a second embodiment of a process for manufacturing non-volatile memory cells according to the invention.

### Detailed description

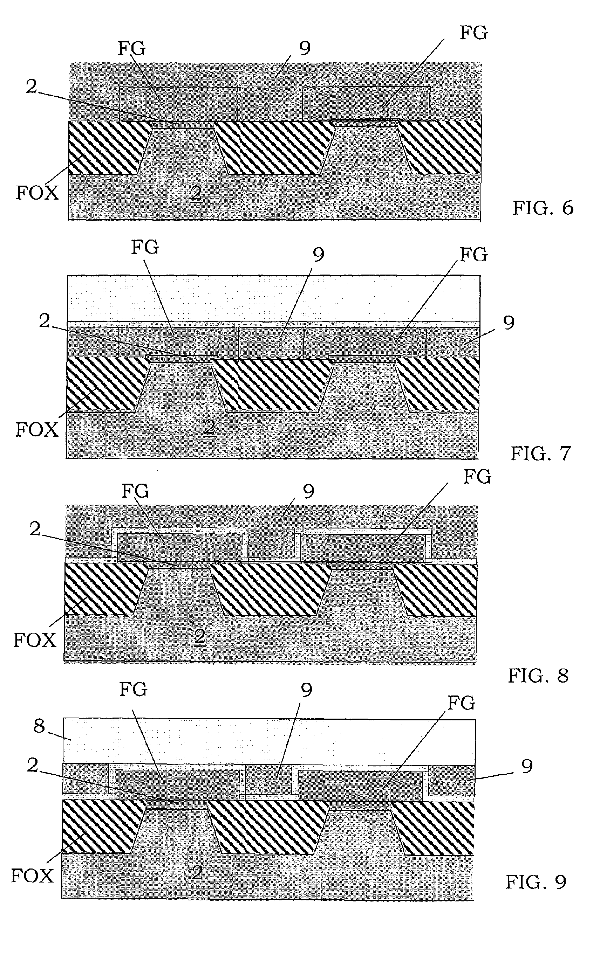

With reference to figures 6 to 9, a floating gate memory cell 1 insulated through dielectric layers with low dielectric constant K value is described.

A corresponding manufacturing process of this cell 1 is also described.

The process steps described hereafter do not form a complete process flow for manufacturing integrated circuits. The present invention can be implemented together with the techniques for manufacturing integrated circuits currently used in this field, and only those currently used process steps which are necessary for understanding the present invention are included.

The figures which are schematic views of portions of an integrated circuit during the manufacturing thereof are not drawn to scale, but they are instead drawn so as to show the important features of the invention.

As described for the prior art, each non-volatile cell 1 comprises a floating gate MOS transistor. The floating gate region FG of the floating gate transistor is formed above the channel region CH formed in the semiconductor substrate 2 and separated by the latter through a thin oxide layer 3 (tunnel oxide), being 6-12 nm thick. A control gate region CG is coupled in a capacitive way to the floating gate region FG through a single dielectric layer 5 or comprising several overlapped dielectric layers such as for example ONO (oxide-nitride-oxide).

According to the invention a dielectric layer 9 with low dielectric constant is formed between floating gate regions FG belonging to the same memory cell matrix row in order to reduce the coupling between adjacent cells 1.

After all, this dielectric layer 9 with low dielectric constant insulates a floating gate region FG from the adjacent regions along the direction of the memory cell width W.

The process for forming a memory cell 1 according to the invention is now described.

On a substrate 2 a plurality of active areas is formed, wherein memory cells 1, separated from each other by portions of a field oxide layer FOX, will be formed. A first active dielectric layer 3 and a layer 4 made of a conductor material, like for example polycrystalline silicon referred to as POLY1, are then formed on the substrate 2.

Advantageously, this first active dielectric layer 3 is an oxide layer referred to as "Tunnel Oxide" and it is formed on the substrate 2 through a thermal oxidation step.

This polycrystalline silicon layer 4 being about 50-200 nm thick is formed for example through LPCVD (Low Pressure Chemical Vapour Deposition). This polycrystalline silicon layer 4 is, in case, doped to reduce the resistivity thereof, for example through a phosphorus or arsenic implant or in situ by adding phosphin to the deposition environment.

The process continues with the definition of layer 4 to form a plurality of polycrystalline silicon strips 5 being parallel to each other. These strips 5 are separated and insulated from the substrate 2 by means of the oxide layer 3 as shown in figure 3.

Particularly, in this step, a photosensitive material layer 6 referred to as resist is deposited on the substrate 2 surface and it is exposed to a convenient radiation in predetermined areas which are not protected by a mask. The resist portions selectively exposed to the radiation have a higher removing speed than the non-exposed regions and they can thus be removed through a chemical solution referred to as developer. After the lithographic definition a dry etching of the polycrystalline silicon strips 5 is performed to define the floating gate regions FG.

Advantageously, a first oxidation step, for example a RTO (Rapid Thermal Oxidation), is performed in a dry environment, obtaining a first very thin dielectric layer of about 1-2 nm, not shown in figures. This first dielectric layer is capable of protecting the walls of the floating gate region FG.

A layer 9 made of a low dielectric constant K material is then formed in order to fill up an area between two adjacent floating gate regions FG belonging to a same small-sized row.

This layer 9 made of a low dielectric constant material is a layer made of an organic or inorganic material such as for example a silicon oxide layer being doped for example with fluorine (FSG Fluorinate Silicate Glass having a dielectric constant comprised between 3.3 and 3.7) or with carbon (for example with alkylic groups, k=2.7-3.1).

These dielectric layers 9 are advantageously deposited through different techniques such as CVD (Chemical Vapour Deposition), HDPCVD (High-Density Plasma Enhanced Chemical Vapour Deposition) or the so-called spin-on-glass technique.

Particularly, the dielectric layers 9 deposited through these latter techniques have also a high planarising capacity.

Advantageously other dielectric layers 9 are used, such as for example porous silice, with a dielectric constant K which is slightly higher than 1.

Advantageously the dielectric layer 9 is subjected to a densification process in order to improve the constant dielectric thereof.

A selective back etching step towards the polysilicon layer 4 is then performed through CMP or standard back etching techniques in order to leave the floating gate region FG exposed.

The deposition of an interpoly dielectric layer 7 and of a second polysilicon layer 8, being for example about 100-400 nm thick, is performed to form the control gate region of cell 1 as shown in figure 7.

A second method for performing the insulation between floating gate regions FG is shown in figures 8-9.

After forming conventionally the floating gate regions FG as shown in figure 4, an interpoly dielectric layer 7 is formed.

This interpoly dielectric layer 7 is a single oxide layer (of silicon or hafnium or tellurium or other equivalent materials) or it comprises several overlapped layers such as for example an ONO layer (oxide-nitride-oxide) being about 10-25 nm thick.

A layer 9 made of a low dielectric constant K material is then formed in order to fill up an area between two small-sized adjacent floating gate regions FG.

This layer 9 made of a low dielectric constant material is a layer made of an organic or inorganic material as in the previous embodiment.

A selective back etching towards the interpoly dielectric layer and the deposition of the second polysilicon layer being about 150-250 nm thick (figure 9) are then performed, which can be preceded by a slight oxidation (or deposition of an equivalent layer) which, through a short thermal treatment and a secondary impact on the final thickness of the interpoly dielectric layer, succeeds in insulating the low-k material from the above polysilicon layer, inhibiting the mutual interaction.

This second method is obviously applied when the distance between two adjacent floating gates is higher than twice the effective thickness of the high-k dielectric layer 7 (ONO or other above-mentioned multi-layer materials) deposited on the walls of the floating gate region FG.

In conclusion, the insertion of a layer with low dielectric constant value reduces interaction problems between adjacent floating gate regions FG caused by the reduction of the area between two adjacent regions FG.

This process is thus particularly advantageous when using dielectric material layers with high dielectric constant value K as interpoly dielectric layers to improve the capacitive couplings in memory cells 1.

## Claims

1. A non-volatile memory cell (1) integrated on a semiconductor substrate (2) and comprising:
- a floating gate transistor'including a source region (S) and a drain region (G), a gate region projecting from the substrate (2) and comprised between said source and drain regions (S, D), said gate region having a predetermined length (L) and width (W) and comprising a first floating gate region (FG) and a control gate region (CG),
**characterised in that** said floating gate region (FG) is insulated laterally, along the width (W) direction, by a dielectric layer (9) with low dielectric constant value (K).

2. A memory cell according to claim 1, **characterised in that** said floating gate regions (FG) are covered by a dielectric layer (7) before being insulated from each other through said dielectric layer (9) with low dielectric constant value (K).

3. A memory cell according to claim 1, **characterised in that** said dielectric layer (9) with low dielectric constant value (K) is bounded between said floating gate regions (FG).

4. A memory cell according to claim 1, **characterised in that** said dielectric layer (9) with low dielectric constant value (K) is formed by a layer of material having a dielectric constant comprised between 1 and 3.9.

5. A memory cell according to claim 1, **characterised in that** said dielectric layer (9) with low dielectric constant value (K) is formed by a silicon oxide layer doped for example with fluorine.

6. A memory cell according to claim 1, **characterised in that** said dielectric layer (9) with low dielectric constant value (K) is formed by a carbon oxide layer hydrated with alkylic groups.

7. A process for manufacturing non-volatile memory cells (1) on a semiconductor substrate (2) organised in rows and columns to form a memory cell matrix, comprising the following steps:
- form active areas in said semiconductor substrate (2) bounded by an insulating layer (FOX),
- form on said active areas a first dielectric material layer (3),
- deposit a first conductor material layer (5) on said first dielectric material layer (3),
- define through a standard photolithographic technique a plurality of floating gate regions (FG) in said first conductor material layer (5),
**characterised in that** it comprises the following steps:
- form a dielectric layer (9) with low dielectric constant value (K) on said floating gate regions (FG).

8. A process for manufacturing non-volatile memory cells (1) according to claim 7, **characterised in that** said dielectric layer (9) with low dielectric constant value (K) is bounded between said adjacent floating gate regions (FG) belonging to the same row.

9. A process for manufacturing non-volatile memory cells (1) according to claim 7, **characterised in that** said dielectric layer (9) with low dielectric constant value (K) is deposited through CVD techniques.

10. A process for manufacturing non-volatile memory cells (1) according to claim 7, **characterised in that** said dielectric layer (9) with low dielectric constant value (K) is deposited through spin on glass techniques.

11. A process for manufacturing non-volatile memory cells (1) according to claim 7, **characterised in that** said dielectric layer (9) with low dielectric constant value (K) is formed by a layer of material having a dielectric constant comprised between 1 and 3.9.

12. A process for manufacturing non-volatile memory cells (1) according to claim 7, **characterised in that** said dielectric layer (9) with low dielectric constant value (K) is formed by a silicon oxide layer doped for example with fluorine.

13. A process for manufacturing non-volatile memory cells (1) according to claim 7, **characterised in that** said dielectric layer (9) with low dielectric constant value (K) is formed by a carbon oxide layer hydrated with alkylic groups.

14. A process for manufacturing non-volatile memory cells (1) according to claim 7, **characterised in that** said floating gate regions (FG) are covered by a dielectric layer before being insulated from each other through said dielectric layer (9) with low dielectric constant value (K).

15. A memory cell matrix formed on a semiconductor substrate comprising a plurality of memory cells organised in rows and columns, each cell being formed according to any of the claims from 1 to 6, the cell matrix being **characterised in that** adjacent memory cells belonging to a same row of said memory cell matrix are insulated from each other by a dielectric layer (9) with low dielectric constant value (K).
